# EUROPEAN PATENT APPLICATION

(11) **EP 3 690 547 A1**
(43) Date of publication of application: **05.08.2020**
(21) Application number: 18860506.7
(22) Date of filing: 28.09.2018
(51) Int. Cl.: G03F 7/004, C07F 11/00, G03F 7/029, G03F 7/038, G03F 7/20

(54) **COMPOSITION FOR LITHOGRAPHY, PATTERN FORMATION METHOD AND COMPOUND**

(30) Priority: 29.09.2017 JP 2017189340
(71) Applicant: The School Corporation Kansai University, Suita-shi, Osaka 564-8680 (JP); Mitsubishi Gas Chemical Company, Inc., Tokyo 100-8324 (JP)
(72) Inventor: KUDO, Hiroto, Suita-shi Osaka 564-8680 (JP); ECHIGO, Masatoshi, Tokyo 100-8324 (JP); SATO, Takashi, Hiratsuka-shi Kanagawa 254-0016 (JP)
(74) Representative: Müller-Boré & Partner Patentanwälte PartG mbB
(86) International application number: PCT/JP2018/036344
(87) International publication number: WO 2019/066000

(57) **Abstract**

A composition for lithography, comprising a compound represented by following formula (1):

[LₓTe(OR¹)_{y}] (1)

wherein L represents a ligand other than OR¹; R¹ represents any one of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms; x represents an integer of 0 to 6; y represents an integer of 0 to 6; a total of x and y represents 1 to 6; when x represents 2 or more, a plurality of L may be the same or different from each other, and when y represents 2 or more, a plurality of R¹ may be the same or different from each other.

## Description

### Technical Field

The present invention relates to a composition for lithography, a pattern formation method, and a compound.

### Background Art

In the production of semiconductor devices, fine processing is practiced by lithography using photoresist materials. In recent years, further miniaturization based on pattern rules has been demanded along with increase in the integration and speed of large scale integrated circuits (LSI). The light source for lithography used upon forming resist patterns has been shifted to ArF excimer laser (oscillation wavelength: 193 nm) having a shorter wavelength from KrF excimer laser (oscillation wavelength: 248 nm). The introduction of electron beam or extreme ultraviolet (hereinafter, referred to as "EUV") (oscillation wavelength: 13.5 nm) is also expected.

However, because conventional polymer-based resist materials have a molecular weight as large as about 10,000 to 100,000 and also wide molecular weight distribution, in lithography using such a polymer-based resist material, roughness occurs on a pattern surface; the pattern dimension becomes difficult to be controlled; and there is a limitation in miniaturization.

Accordingly, in order to provide resist patterns having higher resolution, it has been proposed to use resist materials containing various low molecular weight components. The low molecular weight resist materials are expected to provide resist patterns having high resolution and small roughness, because of their small molecular sizes.

As an example of using a low molecular weight resist material, for example, an alkaline development type negative type radiation-sensitive composition (see, for example, Patent Literature 1 and Patent Literature 2) using a low molecular weight polynuclear polyphenolic compound as a main component has been proposed. In addition, as an example of a low molecular weight resist material having high sensitivity and high heat resistance, an alkaline development type negative type radiation-sensitive composition (see, for example, Patent Literature 3) using a low molecular weight cyclic polyphenolic compound as a main component has been proposed as well.

Furthermore, lithography using electron beam or EUV has a reaction mechanism different from that of normal photolithography. Lithography with electron beam or EUV aims at forming fine patterns of tens of nm. Accordingly, there is a demand for a resist material having higher sensitivity for an light exposing source with decrease in resist pattern dimension. Particularly, lithography with EUV needs to achieve higher sensitivity of a resist composition in terms of throughput.

As a resist material that solves these problems, inorganic resist materials containing any one of titanium, hafnium and zirconium have been proposed (see, for example, Patent Literature 4 and Patent Literature 5).

Patent Literature 1: Japanese Patent Laid-Open No. 2005-326838
Patent Literature 2: Japanese Patent Laid-Open No. 2008-145539
Patent Literature 3: Japanese Patent Laid-Open No. 2009-173623
Patent Literature 4: Japanese Patent Laid-Open No. 2015-75500
Patent Literature 5: Japanese Patent Laid-Open No. 2015-108781

### Summary of Invention

### Technical Problem

However, in Patent Literatures 1 to 3, the storage stability of the radiation-sensitive compositions is not investigated. In Patent Literature 4, the storage stability of the resist material is not investigated, and for the resist material in this literature as well, it is demanded to make the storage stability even more satisfactory and, for example, to allow resist patters to be obtained even more stably. In addition, it is demanded for the resist material in this literature to further improve sensitivity. In Patent Literature 5, the storage stability of the resist material is evaluated, but evaluation is carried out only on resist materials containing complexes including particular metals (hafnium and zirconium). Furthermore, it cannot be said that resist materials containing complexes including such metals have sufficient sensitivity.

Accordingly, an object of the present invention is, under the above circumstances, to provide a compound that has excellent solubility and that can achieve excellent film formability, pattern formability and storage stability in a well-balanced way when used as a material for lithography; a composition for lithography; and a pattern formation method.

### Solution to Problem

As a result of diligent investigations in order to solve the problems described above, the present inventors have found that a compound having a particular structure containing tellurium has excellent solubility, and when such a compound is used for a material for lithography, it can achieve excellent film formability, pattern formability and storage stability in a well-balanced way, and have completed the present invention.

[1] A composition for lithography, comprising a compound represented by following formula (1):

   [LₓTe(OR¹)_{y}] (1)

   wherein L represents a ligand other than OR¹; R¹ represents any one of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms; x represents an integer of 0 to 6; y represents an integer of 0 to 6; a total of x and y represents 1 to 6; when x represents 2 or more, a plurality of L may be the same or different from each other, and when y represents 2 or more, a plurality of R¹ may be the same or different from each other.
[2] The composition for lithography according to [1], wherein, in the compound represented by formula (1), x represents an integer of 1 to 6.
[3] The composition for lithography according to [1] or [2], wherein, in the compound represented by formula (1), y represents an integer of 1 to 6.
[4] The composition for lithography according to any one of [1] to [3], wherein, in the compound represented by formula (1), R¹ represents a substituted or unsubstituted, linear alkyl group having 1 to 6 carbon atoms or branched or cyclic alkyl group having 3 to 6 carbon atoms.
[5] The composition for lithography according to any one of [1] to [4], wherein, in the compound represented by formula (1), L represents a bi- or higher-dentate ligand.
[6] The composition for lithography according to any one of [1] to [5], wherein, in the compound represented by formula (1), L represents any one of acetylacetonato, 2,2-dimethyl-3,5-hexanedione, ethylenediamine, diethylenetriamine and methacrylic acid.
[7] The composition for lithography according to any one of [1] to [6], wherein the composition is for a resist.
[8] The composition for lithography according to any one of [1] to [7], further comprising a solvent.
[9] The composition for lithography according to any one of [1] to [8], further comprising an acid generating agent.
[10] The composition for lithography according to any one of [1] to [9], further comprising an acid diffusion controlling agent.
[11] The composition for lithography according to any one of [1] to [10], further comprising a polymerization initiator.
[12] A method for forming a pattern, comprising the steps of:
   forming a resist film on a substrate using the composition for lithography according to any one of [1] to [11];
   exposing the resist film to light; and developing the light exposed resist film, thereby forming a pattern.
[13] A compound represented by following formula (1):

   [LₓTe(OR¹)_{y}] (1)

   wherein L represents a ligand other than OR¹; R¹ represents any one of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms; x represents an integer of 0 to 6; y represents an integer of 0 to 6; a total of x and y represents 1 to 6; when x represents 2 or more, a plurality of L may be the same or different from each other, and when y represents 2 or more, a plurality of R¹ may be the same or different from each other.

### Advantageous Effects of Invention

According to the present invention, a compound that has excellent solubility and that can achieve excellent film formability, pattern formability and storage stability in a well-balanced way when used as a material for lithography; a composition for lithography; and a pattern formation method can be provided.

### Description of Embodiments

Hereinafter, an embodiment of the present invention will be described (hereinafter, referred to as the "present embodiment"). Note that the present embodiment is given in order to illustrate the present invention. The present invention is not limited to the present embodiment.

"solubility" in the specification refers to a character of being apt to be dissolved in a safe solvent. "Film formability" refers to a character that, upon forming a thin film, defects are unlikely to occur in the formed film. "high sensitivity" refers to a character that the minimum irradiation amount of energy necessary to obtain a pattern is small. "pattern formability" refers to a character that, upon forming a resist pattern, the pattern shape is satisfactory. "storage stability" refers to a character that precipitate is unlikely to occur in spite of being stored for a long period of time.

### [Compound]

A compound of the present embodiment is a compound represented by the following formula (1) (also referred to as the "tellurium containing compound").

[LₓTe(OR¹)_{y}] (1)

In formula (1), L represents a ligand other than OR¹; R¹ represents any one of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms; x represents an integer of 0 to 6; y represents an integer of 0 to 6; the total of x and y represents 1 to 6; when x represents 2 or more, a plurality of L may be the same or different from each other, and when y represents 2 or more, a plurality of R¹ may be the same or different from each other.

The tellurium containing compound of the present embodiment has excellent solubility and can achieve excellent film formability, high sensitivity, pattern formability and storage stability in a well-balanced way when used as a material for lithography. The tellurium containing compound of the present embodiment contains a tellurium atom, which has the highest sensitizing effects secondary to xenon among the elements, and mainly due to this, high sensitizing effects can be obtained in lithography (in particular, lithography using EUV). As a result, the compound of the present embodiment is excellent in high sensitivity and pattern formability.

Examples of R¹ include any one of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms. When there are a plurality of R¹, they may be the same as or different from each other.

Specific examples of R¹ include, for example, a methyl group, an ethyl group, a propyl group, a butyl group, a pentyl group, a hexyl group, a heptyl group, an octyl group, a nonyl group, a decyl group, an undecyl group, a dodecyl group, an icosyl group, a cyclopropyl group, a cyclobutyl group, a cyclopentyl group, a cyclohexyl group, a cycloheptyl group, a cyclooctyl group, a cyclononyl group, a cyclodecyl group, a cycloundecyl group, a cyclododecyl group, a cycloicosyl group, a norbornyl group, an adamantyl group, a phenyl group, a naphthyl group, an anthracene group, a pyrenyl group, a biphenyl group, a heptacene group, a vinyl group, an allyl group and an icosynyl group. These groups follow a concept of encompassing isomers, and for example, a butyl group is not limited to a n-butyl group, and may be an isobutyl group, a sec-butyl group or a tert-butyl group. In addition, these groups may have a substituent as long as the number of carbon atoms does not exceed 20, and examples of the substituent include a functional group selected from the group consisting of a carboxyl group, an acryl group and a methacryl group, as well as groups containing these groups. However, when x represents 0 and y represents 4, it is not necessary for all R¹ to be a methyl group.

Among them, from the viewpoint of high sensitivity and raw material availability, R¹ represents preferably a linear alkyl group having 1 to 6 carbon atoms or branched or cyclic alkyl group having 3 to 6 carbon atoms, and is more preferably a linear alkyl group having 1 to 4 carbon atoms or branched or cyclic alkyl group having 3 to 4 carbon atoms. When it has a substituent, that substituent is preferably one or more selected from the group consisting of a carboxyl group, a group containing carboxyl group, an acrylate group and a methacrylate group, and is more preferably one or more selected from the group consisting of an acrylate group and a methacrylate group.

L represents a ligand other than OR¹, and may be a monodentate ligand or a multidentate ligand, i.e., a bi- or higher-dentate ligand. When there are a plurality of L, they may be the same as or different from each other.

Specific examples of the monodentate ligand include acrylate, methacrylate, amine, chloro, cyano, thiocyano, isothiocyano, nitro, nitrito, triphenylphosphine and pyridine. Specific examples of the multidentate ligand include, for example, ethylenediamine, acetylacetonato, diethylenetriamine, ethylenediaminetetraacetic acid and cyclopentene.

From the viewpoint of storage stability, L represents preferably a multidentate ligand, i.e., a bi- or higher-dentate ligand, and is more preferably any one of acetylacetonato, 2,2-dimethyl-3,5-hexanedione, ethylenediamine, diethylenetriamine and methacrylic acid.

x represents an integer of 0 to 6, y represents an integer of 0 to 6, and x + y represents 1 to 6. From the viewpoint of solubility in a safe solvent, x represents preferably an integer of 1 to 6, represents more preferably an integer of 1 to 4, and represents further preferably 1 or 2. From the viewpoint of high sensitivity, y represents preferably an integer of 1 to 6, represents more preferably an integer of 1 to 4, and represents further preferably an integer of 2 to 4.

In the present embodiment, the compound represented by formula (1) is obtained by, for example, the following method. That is, by heating metal tellurium or tellurium dioxide in a chlorine gas stream to about 500°C, tellurium tetrachloride is obtained. Next, by allowing the obtained tellurium tetrachloride to react with sodium alkoxide under ice cooling with no catalyst, an alkoxy tellurium compound, wherein x represents 0 and y represents 1 or more in formula (1), can be obtained. For example, tetraethoxytellurium(IV) represented by the following formula (TOX-1) can be obtained by allowing tellurium tetrachloride to react with ethanol. Alternatively, a tellurium containing compound can be obtained through electrolysis using metal tellurium as the positive electrode.

Te(OEt)₄ (TOX-1)

In the present embodiment, L, which is a ligand other than OR¹, can be obtained by a variety of methods. For example, a tellurium containing compound to which L represents coordinated can be obtained by mixing and stirring an alkoxy tellurium compound or metal tellurium dissolved in an organic solvent such as tetrahydrofuran and a ligand L dissolved in an organic solvent such as tetrahydrofuran, and removing the organic solvent. A specific example is shown below. That is, when tetraexhoxytellurium(IV) represented by formula (TOX-1) is used as an alkoxy tellurium compound, by placing 1.0 g of tetraethoxytellurium(IV) represented by formula (TOX-1) dissolved in 20 mL of tetrahydrofuran in a container with an inner volume of 100 mL equipped with a stirrer, a condenser tube and a burette, further adding 0.6 g of acetylacetone dissolved in 5 mL of tetrahydrofuran, allowing the resultant mixture to reflux for 1 hour, and removing the solvent under reduced pressure, a compound represented by the following formula (TOX-2) can be obtained.

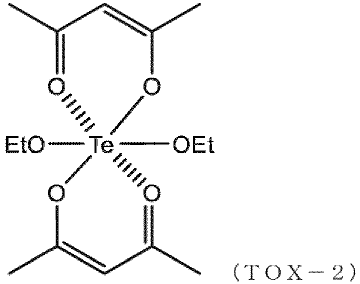

In addition, examples of the compound according to the present embodiment may include, but are not particularly limited to, the following compounds.

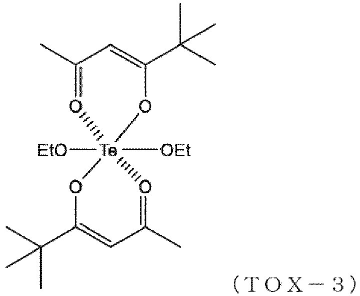

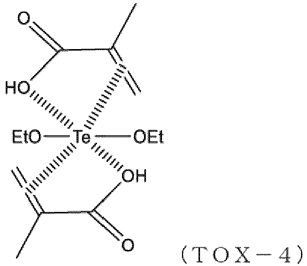

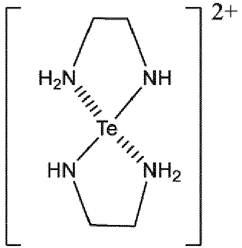

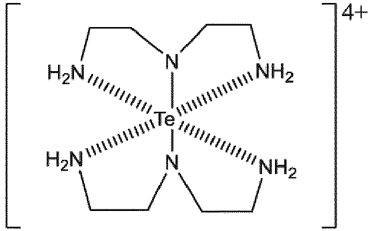

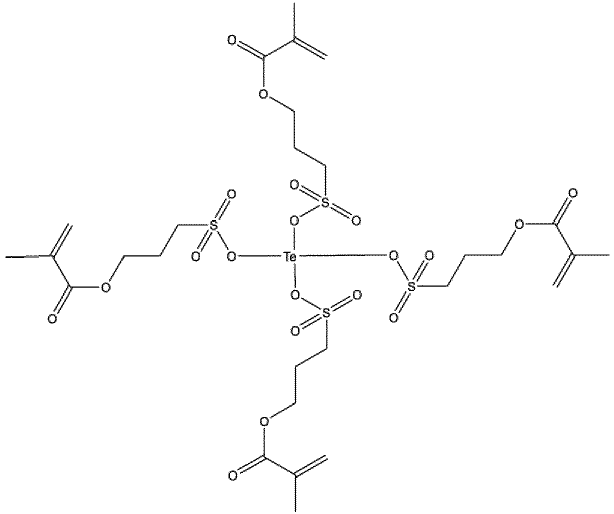

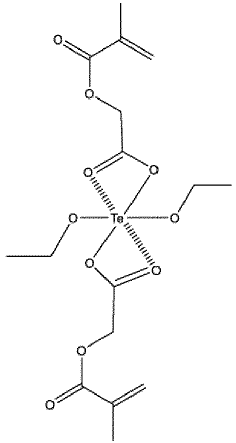

### [Composition for Lithography]

A composition for lithography of the present embodiment contains a compound represented by the above formula (1). In the present embodiment, by adjusting the content, composition and the like of the components in the composition for lithography, the composition can be utilized for a multilayer process such as for a resist. Since the composition for lithography of the present embodiment includes the tellurium containing compound of the present embodiment, the composition can achieve excellent film formability, high sensitivity, pattern formability and storage stability in a well-balanced way.

The composition for lithography of the present embodiment can also be used for applications other than resist (resist film formation), but can be suitably used for a resist.

In the composition for lithography of the present embodiment, other than the compound represented by the above formula (1), a resin that is used as a material for lithography (in particular, resist material) may be contained. The "resin" in the specification refers to a film forming component excluding the tellurium containing compound represented by the above formula (1), and a solvent, an acid generating agent, an acid crosslinking agent, an acid diffusion controlling agent, a polymerization initiator and a further component, all of which will be mentioned later, and follows a concept of encompassing low molecular weight compounds.

Examples of the resin include, but are not particularly limited to, for example, a naphthol resin, a modified resin in which a xylene formaldehyde resin is modified with a phenol (for example, phenol, naphthol or the like), a modified resin in which a naphthalene formaldehyde resin is modified with a phenol (for example, phenol, naphthol or the like), a dicyclopentadiene resin, a novolac resin, a polyvinyl phenol, a polyacrylic acid, a polyvinyl alcohol, a styrene-maleic anhydride resin, and a polymer including acrylic acid, vinyl alcohol or vinylphenol as a monomer unit, or derivatives thereof. These resins can be used alone as one kind or used in combination of two or more kinds. Among them, from the viewpoint of exhibiting effects of the present invention more effectively and reliably, the resin is preferably at least one selected from the group consisting of a naphthol resin, a xylene formaldehyde resin modified with naphthol and a naphthalene formaldehyde resin modified with phenol, and is more preferably a naphthalene formaldehyde resin modified with phenol.

The content of the resin is not particularly limited, and is preferably 1000 parts by mass or less, more preferably 500 parts by mass or less, further preferably 200 parts by mass or less, and particularly preferably 100 parts by mass based on 100 parts by mass of the total amount of the tellurium containing compound of the present embodiment and the resin.

### (Solvent)

It is preferable that the composition for lithography (for example, composition for a resist) of the present embodiment contain a solvent. Examples of the solvent can include, but are not particularly limited to, ethylene glycol monoalkyl ether acetates such as ethylene glycol monomethyl ether acetate, ethylene glycol monoethyl ether acetate, ethylene glycol mono-n-propyl ether acetate, and ethylene glycol mono-n-butyl ether acetate; ethylene glycol monoalkyl ethers such as ethylene glycol monomethyl ether and ethylene glycol monoethyl ether; propylene glycol monoalkyl ether acetates such as propylene glycol monomethyl ether acetate (PGMEA), propylene glycol monoethyl ether acetate, propylene glycol mono-n-propyl ether acetate, and propylene glycol mono-n-butyl ether acetate; propylene glycol monoalkyl ethers such as propylene glycol monomethyl ether (PGME) and propylene glycol monoethyl ether; lactic acid esters such as methyl lactate, ethyl lactate, n-propyl lactate, n-butyl lactate, and n-amyl lactate; aliphatic carboxylic acid esters such as methyl acetate, ethyl acetate, n-propyl acetate, n-butyl acetate, n-amyl acetate, n-hexyl acetate, methyl propionate, and ethyl propionate; other esters such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutylacetate, 3-methyl-3-methoxybutylacetate, butyl 3-methoxy-3-methylpropionate, butyl 3-methoxy-3-methylbutyrate, methyl acetoacetate, methyl pyruvate, and ethyl pyruvate; aromatic hydrocarbons such as toluene and xylene; ketones such as 2-heptanone, 3-heptanone, 4-heptanone, cyclopentanone (CPN), and cyclohexanone (CHN); amides such as N,N-dimethylformamide, N-methylacetamide, N,N-dimethylacetamide, and N-methylpyrrolidone; and lactones such as γ-lactone. These solvents can be used alone as one kind or used in combination of two or more kinds.

The solvent used in the present embodiment is preferably a safe solvent, more preferably at least one selected from PGMEA, PGME, CHN, CPN, 2-heptanone, anisole, butyl acetate, ethyl propionate, and ethyl lactate, and still more preferably at least one selected from PGMEA, PGME, and CHN.

In the present embodiment, the content of the solvent in the composition for lithography (for example, composition for a resist) is not particularly limited, but based on 100% by mass of the composition for lithography (for example, composition for a resist), it is preferable that the content of solid components be 1 to 80% by mass and the content of the solvent be 20 to 99% by mass; it is more preferable that the content of solid components be 1 to 50% by mass and the content of the solvent be 50 to 99% by mass; it is further preferable that the content of solid components be 2 to 40% by mass and the content of the solvent be 60 to 98% by mass; and it is particularly preferable that the content of solid components be 2 to 10% by mass and the content of the solvent be 90 to 98% by mass.

The composition for lithography (for example, composition for a resist) of the present embodiment may contain at least one selected from the group consisting of an acid generating agent (P), an acid crosslinking agent (C), an acid diffusion controlling agent (Q), and a further component (E), as other solid components. Note that the "solid components" in the specification refer to components other than the solvent in the composition for lithography of the present embodiment.

### (Acid Generating Agent)

It is preferable that the composition for lithography (for example, composition for a resist) of the present embodiment contain an acid generating agent that can generate an acid directly or indirectly through irradiation of radiation (for example, EUV). When an acid generating agent is contained, even more excellent high sensitivity and pattern profile with low edge roughness tend to be obtained.

As the acid generating agent, those that are publicly known can be used, and examples thereof include, but are not particularly limited to, for example, compounds described in paragraphs 0077 to 0093 of International Publication No. WO 2013/024778. Among them, the acid generating agent preferably includes compounds having an aromatic ring, and is more preferably a compound (acid generating agent) represented by the following formula (2-1) or (2-2). 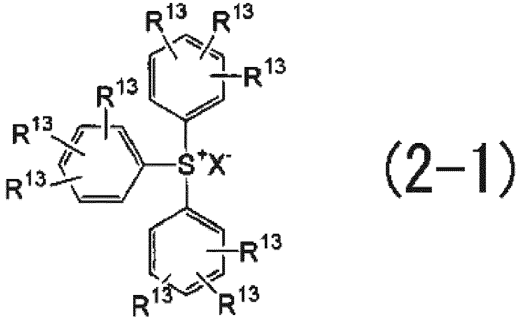 In formula (2-1), R¹³ may be the same or different from each other, and are each independently a hydrogen atom, a linear, branched or cyclic alkyl group, a linear, branched or cyclic alkoxy group, a hydroxyl group, or a halogen atom; and X⁻ is an alkyl group, an aryl group, a sulfonic acid ion having a halogen substituted alkyl group or a halogen substituted aryl group, or a halide ion. 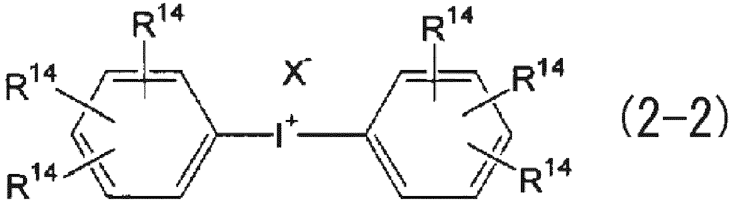 In formula (2-2), R¹⁴ may be the same or different from each other, and each independently represent a hydrogen atom, a linear, branched or cyclic alkyl group, a linear, branched or cyclic alkoxy group, a hydroxyl group, or a halogen atom. X⁻ is the same as described above.

The compound represented by formula (2-1) is preferably at least one selected from the group consisting of triphenylsulfonium trifluoromethanesulfonate, triphenylsulfonium nonafluoro-n-butanesulfonate, diphenyltolylsulfonium nonafluoro-n-butanesulfonate, triphenylsulfonium perfluoro-n-octanesulfonate, diphenyl-4-methylphenylsulfonium trifluoromethanesulfonate, di-2,4,6-trimethylphenylsulfonium trifluoromethanesulfonate, diphenyl-4-butoxyphenylsulfonium trifluoromethanesulfonate, diphenyl-4-t-butoxyphenylsulfonium nonafluoro-n-butanesulfonate, diphenyl-4-hydroxyphenylsulfonium trifluoromethanesulfonate, bis(4-fluorophenyl)-4-hydroxyphenylsulfonium trifluoromethanesulfonate, diphenyl-4-hydroxyphenylsulfonium nonafluoro-n-butanesulfonate, bis(4-hydroxyphenyl)-phenylsulfonium trifluoromethanesulfonate, tri(4-methoxyphenyl)sulfonium trifluoromethanesulfonate, tri(4-fluorophenyl)sulfonium trifluoromethanesulfonate, triphenylsulfonium p-toluenesulfonate, triphenylsulfonium benzenesulfonate, diphenyl-2,4,6-trimethylphenyl-p-toluenesulfonate, diphenyl-2,4,6-trimethylphenylsulfonium-2-trifluoromethylbenzenesulfonate, diphenyl-2,4,6-trimethylphenylsulfonium-4-trifluoromethylbenzenesulfonate, diphenyl-2,4,6-trimethylphenylsulfonium-2,4-difluorobenzenesulfonate, diphenyl-2,4,6-trimethylphenylsulfonium hexafluorobenzenesulfonate, diphenylnaphthylsulfonium trifluoromethanesulfonate, diphenyl-4-hydroxyphenylsulfonium-p-toluenesulfonate, triphenylsulfonium 10-camphorsulfonate, diphenyl-4-hydroxyphenylsulfonium 10-camphorsulfonate, and cyclo(1,3-perfluoropropanedisulfone)imidate.

The compound represented by formula (2-2) is preferably at least one selected from the group consisting of bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium p-toluenesulfonate, bis(4-t-butylphenyl)iodonium benzenesulfonate, bis(4-t-butylphenyl)iodonium-2-trifluoromethylbenzenesulfonate, bis(4-t-butylphenyl)iodonium-4-trifluoromethylbenzenesulfonate, bis(4-t-butylphenyl)iodonium-2,4-difluorobenzenesulfonate, bis(4-t-butylphenyl)iodonium hexafluorobenzenesulfonate, bis(4-t-butylphenyl)iodonium 10-camphorsulfonate, diphenyliodonium trifluoromethanesulfonate, diphenyliodonium nonafluoro-n-butanesulfonate, diphenyliodonium perfluoro-n-octanesulfonate, diphenyliodonium p-toluenesulfonate, diphenyliodonium benzenesulfonate, diphenyliodonium 10-camphorsulfonate, diphenyliodonium-2-trifluoromethylbenzenesulfonate, diphenyliodonium-4-trifluoromethylbenzenesulfonate, diphenyliodonium-2,4-difluorobenzenesulfonate, diphenyliodonium hexafluorobenzenesulfonate, di(4-trifluoromethylphenyl)iodonium trifluoromethanesulfonate, di(4-trifluoromethylphenyl)iodonium nonafluoro-n-butanesulfonate, di(4-trifluoromethylphenyl)iodonium perfluoro-n-octanesulfonate, di(4-trifluoromethylphenyl)iodonium p-toluenesulfonate, di(4-trifluoromethylphenyl)iodonium benzenesulfonate, and di(4-trifluoromethylphenyl)iodonium 10-camphorsulfonate.

The acid generating agent is further preferably the one having a sulfonic acid ion, wherein X⁻ of formula (2-1) or (2-2) has an aryl group or a halogen-substituted aryl group, particularly preferably the one having a sulfonic acid ion, wherein X⁻ of formula (2-1) or (2-2) has an aryl group, and it is particularly preferable that the acid generating agent be one selected from the group consisting of diphenyltrimethylphenylsulfonium p-toluenesulfonate, triphenylsulfonium p-toluenesulfonate, triphenylsulfonium trifluoromethanesulfonate, and triphenylsulfonium nonafluoromethanesulfonate.

The content of the acid generating agent in the composition for lithography of the present embodiment is preferably 0.001 to 49% by mass, more preferably 1 to 40% by mass, further preferably 3 to 30% by mass, and particularly preferably 10 to 25% by mass of the entire mass of solid components. When the content is within the above range, even higher sensitivity and pattern profile with low edge roughness tend to be obtained.

### (Acid Crosslinking Agent)

It is preferable that the composition for lithography of the present embodiment contain an acid crosslinking agent for crosslinking the compound and/or resin, which will be mentioned later, intramolecularly or intermolecularly in the presence of the acid generated from the acid generating agent. The acid crosslinking agent contains, for example, one or more compounds containing a crosslinkable group capable of crosslinking a resin (crosslinkable group containing compound).

As the crosslinkable group containing compound, those that are publicly known can be used, and examples thereof include, but are not particularly limited to, for example, compounds described in paragraphs 0096 to 0123 of International Publication No. WO 2013/024778. These crosslinkable group containing compounds can be used alone as one kind or used in combination of two or more kinds.

The content of the acid crosslinking agent in the composition for lithography of the present embodiment is preferably 0.5 to 49% by mass, more preferably 0.5 to 40% by mass, further preferably 1 to 30% by mass, and particularly preferably 2 to 20% by mass of the entire mass of solid components. When the content is 0.5% by mass or more, there is a tendency that the inhibiting effect of the solubility of a resist film in an alkaline developing solution is improved, decreasing the percentage of remaining film even more, and that occurrence of swelling and meandering of a pattern can be inhibited even more. On the other hand, when the content is 50% by mass or less, there is a tendency that decreases in heat resistance as a resist can be inhibited even more.

### (Acid Diffusion Controlling Agent)

It is preferable that the composition for lithography of the present embodiment contains an acid diffusion controlling agent from the viewpoint of controlling diffusion of the acid generated from the acid generating agent by radiation irradiation in a resist film to inhibit any unpreferable chemical reaction in an unexposed region. When the acid diffusion controlling agent is contained in the composition for lithography of the present embodiment, there is a tendency that the storage stability of the composition for lithography (in particular, resist composition) is improved even more. In addition, along with even further improvement in the resolution, the line width change of a resist pattern due to variation in the post exposure delay time before radiation irradiation and the post exposure delay time after radiation irradiation can be inhibited even more, and the composition tends to have even more excellent process stability.

The acid diffusion controlling agent contains, for example, a radiation degradable basic compound such as a nitrogen atom containing basic compound, a basic sulfonium compound and a basic iodonium compound. More specifically, examples of the radiation degradable basic compound include compounds described in paragraphs 0128 to 0141 of International Publication No. WO 2013/024778. These radiation degradable basic compounds can be used alone as one kind or used in combination of two or more kinds.

The content of the acid diffusion controlling agent in the composition for lithography of the present embodiment is preferably 0.001 to 49% by mass, more preferably 0.01 to 10% by mass, further preferably 0.01 to 5% by mass, and particularly preferably 0.01 to 3% by mass of the entire mass of solid components. When the content is within the above range, there is a tendency that decrease in the resolution, and deterioration of the pattern shape, the dimension fidelity or the like can be inhibited even more. Moreover, even though the post exposure delay time from electron beam irradiation to heating after radiation irradiation becomes longer, the shape of the pattern upper layer portion does not deteriorate. In addition, when the content is 10% by mass or less, there is a tendency that decrease in sensitivity and developability of the unexposed portion or the like can be prevented even more. Furthermore, when such an acid diffusion controlling agent is used, the storage stability of the composition for lithography (in particular, resist composition) is improved even more, and along with even further improvement in the resolution, the line width change of a resist pattern due to variation in the post exposure delay time before radiation irradiation and the post exposure delay time after radiation irradiation can be inhibited even more, thereby making the composition even more excellent in process stability.

### (Further Component)

The composition for lithography of the present embodiment may contain a further component (hereinafter, also referred to as an "arbitrary component") as long as it does not inhibit effects of the present invention. Examples of the further component include a dissolution promoting agent, a dissolution controlling agent, a polymerization initiator, a sensitizing agent, a surfactant, and an organic carboxylic acid or oxo acid of phosphorus, or derivatives thereof, and more specifically, examples thereof include those described in paragraphs 0144 to 0150 of International Publication No. WO 2013/024778. The "further component" in the specification refers to a component excluding the above compound and resin that are used as materials for lithography, acid generating agent, acid crosslinking agent and acid diffusion controlling agent.

The polymerization initiator that can be contained in the composition for lithography of the present embodiment is not limited as long as it can initiate polymerization reaction of one or more components selected from the tellurium containing compound represented by the above formula (1) and the resin through exposure, and polymerization initiators that are publicly known can be contained. Examples of the initiator may include, but are not limited to, a photo-radical polymerization initiator, a photo-cationic polymerization initiator and a photo-anionic polymerization initiator, and from the viewpoint of reactivity, it is preferably a photo-radical polymerization initiator. In addition, it is preferable that a composition containing the above polymerization initiator be a composition by which a negative type resist pattern can be obtained.

Examples of the photo-radical polymerization initiator may include, but are not limited to, alkylphenone-based, acylphosphine oxide-based, and oxyphenylacetic acid ester-based initiators. From the viewpoint of reactivity, alkylphenone-based initiators are preferable, and from the viewpoint of easy availability, 1-hydroxycyclohexyl phenyl ketone (product name: IRGACURE 184 from BASF SE), 2,2-dimethoxy-2-phenylacetophenone (product name: IRGACURE 651 from BASF SE), and 2-hydroxy-2-methyl-1-phenylpropanone (product name: IRGACURE 1173 from BASF SE) are preferable.

### [Content Ratio of Each Component]

In the composition for lithography (for example, composition for a resist) of the present embodiment, the content of the compound and/or resin used as a base material for lithography (for example, resist base material) is not particularly limited, but is preferably 1 to 99% by mass, more preferably 2 to 90% by mass, further preferably 5 to 80% by mass, and particularly preferably 10 to 70% by mass of the entire mass of solid components (the total mass of solid components including the resist base material and optionally used components such as acid generating agent (P), acid crosslinking agent (C), acid diffusion controlling agent (Q), and further component (E)). When the content is within the above range, there is a tendency that the resolution is improved even more, and line edge roughness (LER) is decreased even more.

In the composition for lithography (for example, composition for a resist) of the present embodiment, the contents of the material for lithography (that is, the above tellurium containing compound and resin, hereinafter, also referred to as component (M)), acid generating agent (P), acid crosslinking agent (C), acid diffusion controlling agent (Q) and further component (arbitrary component) (E) (component (M)/acid generating agent (P)/acid crosslinking agent (C)/acid diffusion controlling agent (Q)/arbitrary component (E)) is 1 to 99/0.001 to 49/0 to 49/0.001 to 49/0 to 99, more preferably 2 to 90/1 to 40/0 to 10/0.01 to 10/0 to 90, further preferably 5 to 80/3 to 30/0 to 5/0.01 to 5/0 to 80, and particularly preferably 10 to 70/10 to 25/0 to 3/0.01 to 3/0 to 80. The content ratio of each component is selected from each range such that the total amount thereof is 100% by mass. Through the above content ratio, there is a tendency that performance such as sensitivity, resolution and developability represents excellent.

The resist composition of the present embodiment is generally prepared by dissolving each component in a solvent upon use into a homogeneous solution, and then if required, filtering through a filter or the like with a pore diameter of about 0.2 µm, for example.

### [Physical Properties and the Like of Composition for Lithography (For Example, Resist Composition)]

The resist composition of the present embodiment can form an amorphous film by spin coating. In addition, it can be applied to a general semiconductor production process.

The dissolution rate of the amorphous film formed by spin coating with the composition for lithography (for example, resist composition) of the present embodiment in a developing solution at 23°C is preferably 10 angstrom/sec or more. When the dissolution rate is 10 angstrom/sec or more, the amorphous film more easily dissolves in a developing solution, and is more suitable for lithography (for example, resist). In addition, when the amorphous film has a dissolution rate of 10 angstrom/sec or more, the resolution may be improved. It is presumed that this is because the micro surface portion of the compound represented by the above formula (1) and/or resin dissolves, thereby reducing LER; however, the present invention is not limited in any way by this presumption. Also, there are effects of reducing defects. The dissolution rate can be determined by immersing the amorphous film in a developing solution for a predetermined period of time at 23°C and then measuring the film thickness before and after immersion by a publicly known method such as visual, ellipsometric, or QCM method.

The dissolution rate of the portion exposed by radiation, such as KrF excimer laser, extreme ultraviolet, electron beam or X-ray, of the amorphous film formed by spin coating with the composition for lithography (for example, resist composition) of the present embodiment in a developing solution at 23°C is preferably 5 angstrom/sec or less, more preferably 0.05 to 5 angstrom/sec, and further preferably 0.0005 to 5 angstrom/sec. When the dissolution rate is 5 angstrom/sec or less, the above portion is insoluble in a developing solution, and the composition can thus be used for lithography (for example, resist). When the amorphous film has a dissolution rate of 0.0005 angstrom/sec or more, the resolution may be improved. It is presumed that this is because, due to the change in solubility before and after exposure of the compound represented by the above formula (1) and/or resin, contrast at the interface between the unexposed portion being dissolved in a developing solution and the light exposed portion not being dissolved in a developing solution is increased; however, the present invention is not limited in any way by this presumption. Also, there are effects of reducing LER and defects.

### [Pattern Formation Method]

A pattern formation method (resist pattern formation method) of the present embodiment includes the steps of: forming a resist film on a substrate using the composition for lithography (resist composition) of the present embodiment; exposing the formed resist film to light; and developing the light exposed resist film, thereby forming a pattern (resist pattern). The resist pattern of the present embodiment can also be formed as an upper layer resist in a multilayer process.

Examples of the resist pattern formation method include, but are not particularly limited to, the following methods. At first, a resist film is formed by coating a conventionally publicly known substrate with the above resist composition of the present embodiment using a coating means such as spin coating, flow casting coating, and roll coating (formation step). Examples of the conventionally publicly known substrate include, but are not particularly limited to, a substrate for electronic components, and the one having a predetermined wiring pattern formed thereon, or the like. More specific examples include a silicon wafer, a substrate made of a metal such as copper, chromium, iron and aluminum, and a glass substrate. Examples of the wiring pattern material include, for example, copper, aluminum, nickel, and gold. Also, if required, the substrate may have an inorganic and/or organic film provided thereon. Examples of the inorganic film include an inorganic antireflection film (inorganic BARC). Examples of the organic film include an organic antireflection film (organic BARC). Surface treatment with hexamethylene disilazane or the like may be conducted.

Next, the coated substrate is heated if required. The heating conditions vary according to the compounding composition of the resist composition, or the like, but are preferably 20 to 250°C, and more preferably 20 to 150°C. By heating, the adhesiveness of a resist to a substrate may be improved, which is preferable. Then, the resist film is exposed to light to a desired pattern by any radiation selected from the group consisting of visible light, ultraviolet, excimer laser, electron beam, extreme ultraviolet (EUV), X-ray, and ion beam (exposure step). The exposure conditions or the like are arbitrarily selected according to the compounding composition of the composition for lithography (resist composition), or the like. In the present embodiment, in order to stably form a fine pattern with a high degree of accuracy in exposure, it is preferable that the resist film be heated after radiation irradiation. The heating conditions vary according to the compounding composition of the composition for lithography (composition for a resist), or the like, but are preferably 20 to 250°C, and more preferably 20 to 150°C.

Next, by developing the light exposed resist film in a developing solution, a predetermined resist pattern is formed (development step). As the above developing solution, a polar solvent such as a ketone-based solvent, an ester-based solvent, an alcohol-based solvent, an amide-based solvent, and an ether-based solvent; and a hydrocarbon-based solvent, or an alkaline aqueous solution can be used.

Examples of the ketone-based solvent may include, for example, 1-octanone, 2-octanone, 1-nonanone, 2-nonanone, acetone, 4-heptanone, 1-hexanone, 2-hexanone, diisobutyl ketone, cyclohexanone, methylcyclohexanone, phenylacetone, methyl ethyl ketone, methyl isobutyl ketone, acetylacetone, acetonylacetone, ionone, diacetonyl alcohol, acetyl carbinol, acetophenone, methyl naphthyl ketone, isophorone, and propylene carbonate.

Examples of the ester-based solvent may include, for example, methyl acetate, butyl acetate, ethyl acetate, isopropyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate, and propyl lactate.

Examples of the alcohol-based solvent may include, for example, alcohols such as methyl alcohol, ethyl alcohol, n-propyl alcohol, isopropyl alcohol (2-propanol), n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol; glycol-based solvents such as ethylene glycol, diethylene glycol, and triethylene glycol; and glycol ether-based solvents such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol.

Examples of the ether-based solvent include, for example, dioxane and tetrahydrofuran in addition to the glycol ether-based solvents described above.

As the amide-based solvent, for example, N-methyl-2-pyrrolidone, N,N-dimethylacetamide, N,N-dimethylformamide, hexamethylphosphoric triamide, 1,3-dimethyl-2-imidazolidinone or the like can be used.

Examples of the hydrocarbon-based solvent include, for example, aromatic hydrocarbon-based solvents such as toluene and xylene; and aliphatic hydrocarbon-based solvents such as pentane, hexane, octane, and decane.

A plurality of above solvents may be mixed, or the solvent may be used by mixing the solvent with a solvent other than those described above or water within the range having performance. In order to even more sufficiently exhibit the effect of the present invention, the water content ratio as the whole developing solution is less than 70% by mass, preferably less than 50% by mass, more preferably less than 30% by mass, and further preferably less than 10% by mass. Particularly preferably, the developing solution is substantially moisture free. That is, the content of the organic solvent in the developing solution is, for example, 30% by mass or more and 100% by mass or less, preferably 50% by mass or more and 100% by mass or less, more preferably 70% by mass or more and 100% by mass or less, further preferably 90% by mass or more and 100% by mass or less, and particularly preferably 95% by mass or more and 100% by mass or less based on the entire amount of the developing solution.

Examples of the alkaline aqueous solution include an alkaline compound such as mono-, di- or tri-alkylamines, mono-, di- or tri-alkanolamines, heterocyclic amines, tetramethyl ammonium hydroxide (TMAH), and choline.

Particularly, as the developing solution, a developing solution containing at least one kind of solvent selected from a ketone-based solvent, an ester-based solvent, an alcohol-based solvent, an amide-based solvent, and an ether-based solvent is preferable because it improves resist performance such as resolution and roughness of the resist pattern.

The vapor pressure of the developing solution is preferably 5 kPa or less at 20°C, further preferably 3 kPa or less, and particularly preferably 2 kPa or less. By setting the vapor pressure of the developing solution to 5 kPa or less, the evaporation of the developing solution on the substrate or in a developing cup is inhibited and temperature uniformity within a wafer surface is improved, thereby resulting in improvement in size uniformity within the wafer surface.

Specific examples of the developing solution having a vapor pressure of 5 kPa or less include a ketone-based solvent such as 1-octanone, 2-octanone, 1-nonanone, 2-nonanone, 4-heptanone, 2-hexanone, diisobutyl ketone, cyclohexanone, methylcyclohexanone, phenylacetone, and methyl isobutyl ketone; an ester-based solvent such as butyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxy propionate, 3-methoxy butyl acetate, 3-methyl-3-methoxy butyl acetate, butyl formate, propyl formate, ethyl lactate, butyl lactate, and propyl lactate; an alcohol-based solvent such as n-propyl alcohol, isopropyl alcohol, n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol; a glycol-based solvent such as ethylene glycol, diethylene glycol, and triethylene glycol; a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol; an ether-based solvent such as tetrahydrofuran; an amide-based solvent such as N-methyl-2-pyrrolidone, N,N-dimethylacetamide, and N,N-dimethylformamide; an aromatic hydrocarbon-based solvent such as toluene and xylene; and an aliphatic hydrocarbon-based solvent such as octane and decane.

Specific examples of the developing solution having a vapor pressure of 2 kPa or less, which is in a particularly preferable range, include a ketone-based solvent such as 1-octanone, 2-octanone, 1-nonanone, 2-nonanone, 4-heptanone, 2-hexanone, diisobutyl ketone, cyclohexanone, methylcyclohexanone, and phenylacetone; an ester-based solvent such as butyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxy propionate, 3-methoxy butyl acetate, 3-methyl-3-methoxy butyl acetate, ethyl lactate, butyl lactate, and propyl lactate; an alcohol-based solvent such as n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol; a glycol-based solvent such as ethylene glycol, diethylene glycol, and triethylene glycol; a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol; an amide-based solvent such as N-methyl-2-pyrrolidone, N,N-dimethylacetamide, and N,N-dimethylformamide; an aromatic hydrocarbon-based solvent such as xylene; and an aliphatic hydrocarbon-based solvent such as octane and decane.

To the developing solution, a surfactant can be added in an appropriate amount, if required. The surfactant is not particularly limited, but an ionic or nonionic, fluorine-based and/or silicon-based surfactant or the like can be used, for example. Examples of the fluorine-based and/or silicon-based surfactant may include, for example, the surfactants described in Japanese Patent Application Laid-Open Nos. 62-36663, 61-226746, 61-226745, 62-170950, 63-34540, 7-230165, 8-62834, 9-54432, and 9-5988, and U.S. Pat. Nos. 5,405,720, 5,360,692, 5,529,881, 5,296,330, 5,436,098, 5,576,143, 5,294,511, and 5,824,451. The surfactant is preferably a nonionic surfactant. The nonionic surfactant is not particularly limited, but it is further preferable to use a fluorine-based surfactant or a silicon-based surfactant.

The amount of the surfactant to be used is, for example, 0.001 to 5% by mass, preferably 0.005 to 2% by mass, and further preferably 0.01 to 0.5% by mass based on the entire amount of the developing solution.

As the development method is, for example, a method for dipping a substrate in a bath filled with a developing solution for a fixed time (dipping method), a method for raising a developing solution on a substrate surface by the effect of a surface tension and keeping it still for a fixed time, thereby conducting the development (puddle method), a method for spraying a developing solution on a substrate surface (spraying method), and a method for continuously ejecting a developing solution on a substrate rotating at a constant speed while scanning a developing solution ejecting nozzle at a constant rate (dynamic dispense method), or the like may be applied. The time for conducting the pattern development is not particularly limited, but is preferably 10 seconds to 90 seconds.

In addition, after the step of conducting the development, a step of stopping the development by the replacement with another solvent may be practiced.

After the development, it is preferable that a step of rinsing the resist film with a rinsing solution containing an organic solvent be included.

The rinsing solution used in the rinsing step after the development is not particularly limited as long as the rinsing solution does not dissolve the resist pattern cured by crosslinking. A solution containing a general organic solvent or water may be used as the rinsing solution. As the above rinsing solution, it is preferable to use a rinsing solution containing at least one kind of organic solvent selected from a hydrocarbon-based solvent, a ketone-based solvent, an ester-based solvent, an alcohol-based solvent, an amide-based solvent, and an ether-based solvent. More preferably, after the development, a step of rinsing the film by using a rinsing solution containing at least one kind of organic solvent selected from the group consisting of a ketone-based solvent, an ester-based solvent, an alcohol-based solvent and an amide-based solvent is conducted. Still more preferably, after the development, a step of rinsing the film by using a rinsing solution containing an alcohol-based solvent or an ester-based solvent is conducted. Still more preferably, after the development, a step of rinsing the film by using a rinsing solution containing a monohydric alcohol is conducted. Particularly preferably, after the development, a step of rinsing the film by using a rinsing solution containing a monohydric alcohol having 5 or more carbon atoms is conducted. The time for rinsing the pattern is not particularly limited, but is preferably 10 seconds to 90 seconds.

Herein, examples of the monohydric alcohol used in the rinsing step after the development include a linear, branched or cyclic monohydric alcohol. Specific examples thereof include 1-butanol, 2-butanol, 3-methyl-1-butanol, tert-butyl alcohol, 1-pentanol, 2-pentanol, 1-hexanol, 4-methyl-2-pentanol, 1-heptanol, 1-octanol, 2-hexanol, cyclopentanol, 2-heptanol, 2-octanol, 3-hexanol, 3-heptanol, 3-octanol, and 4-octanol or the like. Examples of the monohydric alcohol having 5 or more carbon atoms to be used, which is particularly preferable, include 1-hexanol, 2-hexanol, 4-methyl-2-pentanol, 1-pentanol, and 3-methyl-1-butanol or the like.

A plurality of these components may be mixed, or the component may be used by mixing the component with an organic solvent other than those described above.

The water content ratio in the rinsing solution is preferably 10% by mass or less, more preferably 5% by mass or less, and particularly preferably 3% by mass or less. By setting the water content ratio to 10% by mass or less, better development characteristics can be obtained.

The vapor pressure at 20°C of the rinsing solution used after the development is preferably 0.05 kPa or more and 5 kPa or less, more preferably 0.1 kPa or more and 5 kPa or less, and most preferably 0.12 kPa or more and 3 kPa or less. By setting the vapor pressure of the rinsing solution to 0.05 kPa or more and 5 kPa or less, the temperature uniformity in the wafer surface is enhanced more, and furthermore, swelling due to permeation of the rinsing solution is further inhibited. As a result, the dimensional uniformity in the wafer surface is further improved.

The rinsing solution may also be used after adding an appropriate amount of a surfactant to the rinsing solution.

In the rinsing step, the wafer after the development is subjected to rinsing treatment using the above organic solvent-containing rinsing solution. The method for the rinsing treatment is not particularly limited. However, for example, a method for continuously ejecting a rinsing solution on a substrate spinning at a constant speed (spin coating method), a method for dipping a substrate in a bath filled with a rinsing solution for a fixed time (dipping method), and a method for spraying a rinsing solution on a substrate surface (spraying method), or the like can be applied. Above all, it is preferable to conduct the rinsing treatment by the spin coating method and after the rinsing, spin the substrate at a rotational speed of 2,000 rpm to 4,000 rpm, to remove the rinsing solution from the substrate surface.

After forming the resist pattern, a pattern wiring substrate is obtained by etching. Etching can be conducted by a publicly known method such as dry etching using plasma gas, and wet etching with an alkaline solution, a cupric chloride solution, and a ferric chloride solution or the like.

After forming the resist pattern, plating can also be conducted. Examples of the above plating method include copper plating, solder plating, nickel plating, and gold plating.

The remaining resist pattern after etching can be peeled by an organic solvent. Examples of the above organic solvent include PGMEA (propylene glycol monomethyl ether acetate), PGME (propylene glycol monomethyl ether), and EL (ethyl lactate). Examples of the above peeling method include, for example, a dipping method and a spraying method. A wiring substrate having a resist pattern formed thereon may be a multilayer wiring substrate, and may have a small diameter through hole.

In the present embodiment, the wiring substrate can also be formed by a method for forming a resist pattern, then depositing a metal in vacuum, and subsequently dissolving the resist pattern in a solution, that is, a liftoff method.

### Examples

The present invention will be more specifically described with reference to examples below. However, the present invention is not limited to these examples. Hereinafter, methods for measuring a compound and methods for evaluating resist performance and the like in examples are presented.

### [Measurement Method]

### (1) Structure of Compound

The structure of the compound was verified by carrying out ¹H-NMR measurement under the following conditions using a product from Bruker, "Advance 600 II spectrometer".
Frequency: 400 MHz
Solvent: CDCl₃
Internal standard: TMS
Measurement temperature: 23°C

### [Evaluation Method]

### (1) Evaluation of Solubility (Evaluation of Safe Solvent Solubility Test of Compound)

The solubility in propylene glycol monomethyl ether acetate (PGMEA) at room temperature (23°C) was evaluated according to the following criteria. The compound was precisely weighed into a test tube, PGMEA was added thereto so as to attain a predetermined concentration, ultrasonic waves were applied for 30 minutes in an ultrasonic cleaner, and then the subsequent state of the fluid was observed visually. In the table, solubility evaluation for Examples 1 to 4 corresponds to solubility evaluation for Compound A alone, and solubility evaluation for Comparative Example 1 corresponds to solubility evaluation for CR-1 alone.
A: amount of dissolution was 5.0% by mass or more.
B: amount of dissolution was 3.0% by mass or more and 5.0% by mass or less.
C: amount of dissolution was less than 3.0% by mass.

### (2) Evaluation of Storage Stability and Film Formability of Resist Composition

By leaving the resist composition to stand still at 23°C and 50% RH for 3 days, and visually observing the presence or absence of precipitates, the storage stability of the resist composition was evaluated according to the following criteria.
A: homogeneous solution without precipitates.
C: precipitates were observed.

Immediately after being prepared, the homogeneous resist composition was spin coated onto a clean silicon wafer, and then prebaked (PB) before exposure in an oven of 110°C to form a resist film with a thickness of 40 nm. The appearance of the formed resist film was evaluated according to the following criteria. When the evaluation is A, it means that the film formability is superior.
A: large defects were not observed in the formed film.
C: large defects were observed in the formed film.

### (3) Evaluation of Reactivity and Pattern Formability of Resist Composition (Method A)

Immediately after being prepared, the homogeneous resist composition was spin coated onto a clean silicon wafer, and then prebaked (PB) before exposure in an oven of 110°C to form a resist film with a thickness of 60 nm. The formed resist film was irradiated with electron beams of 1:1 line and space setting with 50 nm, 40 nm and 30 nm intervals using an electron beam lithography system (a product from ELIONIX INC., "ELS-7500"). After irradiation, the resist film was heated at each predetermined temperature for 90 seconds, and immersed in an alkaline developing solution containing 2.38% by mass of tetramethylammonium hydroxide (TMAH) for 60 seconds for development. Subsequently, the resist film was washed with ultrapure water for 30 seconds, and dried to form a positive type resist pattern. The line and space of the formed resist pattern were observed with a scanning electron microscope (a product from Hitachi High-Technologies Corporation, "S-4800") to evaluate the reactivity and pattern formability of the resist composition by electron beam irradiation.

Based on the smallest energy quantity per unit area necessary for obtaining patterns, that is, based on the sensitivity, the reactivity was evaluated according to the following criteria.
A: the pattern was obtained at less than 50 µC/cm².
C: the pattern was obtained at 50 µC/cm² or more.

The shape of the formed pattern was observed with SEM, and the pattern formability was evaluated according to the following criteria.
A: a rectangular pattern was obtained.
B: an almost rectangular pattern was obtained.
C: a non-rectangular pattern was obtained.

### (4) Evaluation of Reactivity and Pattern Formability of Resist Composition (Method B)

The pattern formability was evaluated by the same method as the above Evaluation of Reactivity and Pattern Formability of Resist Composition (Method A) except that n-butyl acetate was used instead of the alkaline developing solution containing 2.38% by mass of tetramethylammonium hydroxide (TMAH).

### (Synthesis Example 1-1) Synthesis of CR-1

A four necked flask (internal capacity: 10 L) equipped with a Dimroth condenser tube, a thermometer, and a stirring blade and having a detachable bottom was prepared. To this four necked flask, 1.09 kg (7 mol) of 1,5-dimethylnaphthalene (manufactured by Mitsubishi Gas Chemical Co., Inc.), 2.1 kg (28 mol as formaldehyde) of 40% by mass of an aqueous formalin solution (manufactured by Mitsubishi Gas Chemical Co., Inc.), and 0.97 mL of 98% by mass of sulfuric acid (manufactured by Kanto Chemical Co., Inc.) were fed in the current of nitrogen, and the mixture was reacted for 7 hours while being refluxed at 100°C at normal pressure. Subsequently, 1.8 kg of ethylbenzene (a special grade reagent manufactured by Wako Pure Chemical Industries, Ltd.) was added as a diluting solvent to the reaction solution, and the mixture was left to stand still, followed by removal of an aqueous phase as a lower phase. Neutralization and washing with water were further performed, and ethylbenzene and unreacted 1,5-dimethylnaphthalene were distilled off under reduced pressure to obtain 1.25 kg of a dimethylnaphthalene formaldehyde resin as a light brown solid.

Subsequently, a four necked flask (internal capacity: 0.5 L) equipped with a Dimroth condenser tube, a thermometer, and a stirring blade was prepared. To this four necked flask, 100 g (0.51 mol) of the dimethylnaphthalene formaldehyde resin obtained as described above, and 0.05 g of p-toluenesulfonic acid were added in a nitrogen stream, and the temperature was raised to 190°C at which the mixture was then heated for 2 hours, followed by stirring. Subsequently, 52.0 g (0.36 mol) of 1-naphthol was added thereto, and the temperature was further raised to 220°C at which the mixture was reacted for 2 hours. After dilution with a solvent, neutralization and washing with water were performed, and the solvent was distilled off under reduced pressure to obtain 126.1 g of a modified resin (CR-1) as a black-brown solid. Note that the obtainment of the modified resin was confirmed by the ¹H-NMR measurement results. The molecular weight of the obtained resin was as follows; Mn: 885, Mw: 2220, and Mw/Mn: 4.17.

### (Synthesis Example 1-2) Synthesis of CR-1-BOC

In a container (internal capacity: 200 mL) equipped with a stirrer, a condenser tube, and a burette, 10 g of the obtained compound (CR-1) and 5.5 g (25 mmol) of di-t-butyl dicarbonate (manufactured by Sigma-Aldrich) were fed to 100 mL of acetone, 3.45 g (25 mmol) of potassium carbonate (manufactured by Sigma-Aldrich) was added, and the contents were allowed to react by stirring them at 20°C for 6 hours to obtain a reaction solution. Next, the reaction solution was concentrated, and the reaction product was precipitated by the addition of 100 g of pure water to the concentrate, cooled to room temperature, and then filtered to separate solid matter.

The obtained solid matter was washed with water and dried under reduced pressure to obtain 4 g of a modified resin (CR-1-BOC) as a black solid.

### (Synthesis Example 2) Synthesis of TOX-2

In a container (internal capacity: 100 mL) equipped with a stirrer, a condenser tube, and a burette, 1.0 g (2.8 mmol) of tetraethoxytellurium(IV) (a product from Alfa Aesar, purity: 85%) dissolved in 20 mL of tetrahydrofuran was placed, and 0.6 g (6.0 mmol) of acetylacetone dissolved in 5 mL of tetrahydrofuran was further added thereto. After refluxing for 1 hour, the solvent was distilled off under reduced pressure, thereby obtaining 0.6 g of a compound represented by the following formula (TOX-2).

The obtainment of the compound represented by formula (TOX-2) was confirmed by the NMR chemical shifts before and after the reaction.

**[Table 1]**

| Ligand | Proton | Chemical shift (ppm) | |
|---|---|---|---|
| | | Before reaction | After reaction |
| Acetylacetone | -CH₃ | 2.2 | 2.3 |
| | -CH₂-(keto form) | 3.6 | Not observed |
| | -CH= (enol form) | 5.5 | 5.4 |
| | -OH (enol form | 15.8 | Not observed |

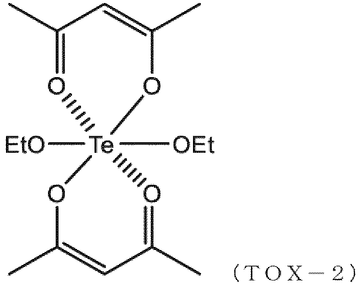

### (Synthesis Example 3) Synthesis of TOX-3

In a container (internal capacity: 100 mL) equipped with a stirrer, a condenser tube, and a burette, 1.0 g (2.8 mmol) of tetraethoxytellurium(IV) (a product from Alfa Aesar, purity: 85%) dissolved in 20 mL of tetrahydrofuran was placed, and 0.8 g (5.6 mmol) of 2,2-dimethyl-3,5-hexanedione dissolved in 5 mL of tetrahydrofuran was further added thereto. After refluxing for 1 hour, the solvent was distilled off under reduced pressure, thereby obtaining 0.7 g of a compound represented by the following formula (TOX-3).

The obtainment of the compound represented by formula (TOX-3) was confirmed by the NMR chemical shifts before and after the reaction.

**[Table 2]**

| Ligand | Proton | Chemical shift (ppm) | |
|---|---|---|---|
| | | Before reaction | After reaction |
| 2,2-Dimethyl-3,5-hexanedione | -(CH₃)₃ | 1.2 | 1.3 |
| | -CH₃ | 2.1 | 2.2 |
| | -CH₂-(keto form) | 3.7 | Not observed |
| | -CH= (enol form | 5.7 | 5.6 |
| | -OH (enol form) | 15.8 | Not observed |

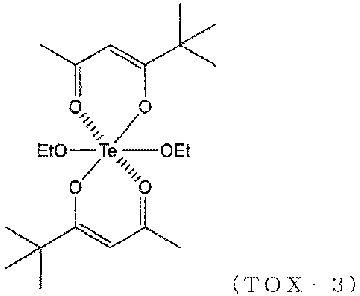

### (Synthesis Example 4) Synthesis of TOX-4

In a container (internal capacity: 100 mL) equipped with a stirrer, a condenser tube, and a burette, 1.0 g (2.8 mmol) of tetraethoxytellurium(IV) (a product from Alfa Aesar, purity: 85%) dissolved in 20 mL of tetrahydrofuran was placed, and 0.5 g (5.8 mmol) of methacrylic acid was further added thereto. After refluxing for 1 hour, the solvent was distilled off under reduced pressure, thereby obtaining 0.5 g of a compound represented by the following formula (TOX-4).

The obtainment of the compound represented by formula (TOX-4) was confirmed by the NMR chemical shifts before and after the reaction.

**[Table 3]**

| Ligand | Proton | Chemical shift (ppm) | |
|---|---|---|---|
| | | Before reaction | After reaction |
| Methacrylic acid | -CH₃ | 2.0 | 1.9 |
| | =CH₂(1 ) | 5.7 | 5.6 |
| | =CH₂(2) | 6.3 | 6.2 |
| | -COOH | 12.0 | 7.9 |

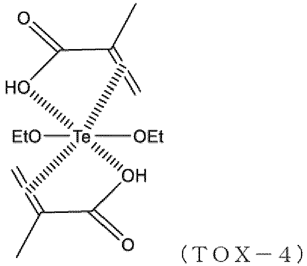

### [Examples 1 to 6]

Resist compositions of Examples 1 to 6 and Comparative Example 1 were prepared according to the compounding amounts shown in the following Table 1 (in the table, numerical values indicate parts by mass) of tetraethoxytellurium(IV) (a product from Alfa Aesar, purity: 85%) and the compounds synthesized in Synthesis Examples 2 to 4; the naphthol-modified resin (CR-1) synthesized in Synthesis Example 1-1; an acid generating agent (a product from Midori Kagaku Co., Ltd., triphenylsulfonium trifluoromethanesulfonate); an acid crosslinking agent (a product from Sanwa Chemical Co., Ltd., "NIKALAC MX270"); an acid diffusion controlling agent (a product from Tokyo Chemical Industry Co., Ltd., trioctylamine); and a solvent (a product from Tokyo Chemical Industry Co., Ltd., propylene glycol monomethyl ether acetate). For each of the prepared resist compositions, the above evaluations (1) to (3) were carried out. Note that, for the above evaluation (1), evaluation of the solubility of compound A and CR-1 constituting the compositions of Examples 1 to 6 and the solubility of CR-1 constituting the composition of Comparative Example 1 was carried out. The evaluation results are shown in Table 4.

**[Table 4]**

| | | Example 1 | Example 2 | Example 3 | Example 4 | Example 5 | Example 6 | Comparative Example 1 |
|---|---|---|---|---|---|---|---|---|
| Composition | Compound A | TOX-1 0.5 | TOX-2 0.5 | TOX-3 0.5 | TOX-4 0.5 | TOX-1 1 | TOX-2 1 | None |
| | CR-1 | 0.5 | 0.5 | 0.5 | 0.5 | 0 | 0 | 1 |
| | Acid generating agent | 0.3 | 0.3 | 0.3 | 0.3 | 0 | 0 | 0.3 |
| | Acid crosslinking agent | 0.3 | 0.3 | 0.3 | 0.3 | 0 | 0 | 0.3 |
| | Acid diffusion controlling agent | 0.03 | 0.03 | 0.03 | 0.03 | 0 | 0 | 0.03 |
| | Solvent | 50 | 50 | 50 | 50 | 25 | 25 | 50 |
| Evaluation | Solubility | A | A | A | A | A | A | A |
| | Storage stability | A | A | A | A | A | A | A |
| | Film formability | A | A | A | A | A | A | A |
| | Reactivity | A | A | A | A | C | C | C |
| | Pattern formability (method A) | A | A | A | A | A | A | C |

As is evident from Table 1, it was confirmed that the compounds used in Examples 1 to 6 have excellent solubility in a safe solvent at the same level as CR-1.

For the film formability, it was confirmed that the resist compositions of Examples 1 to 6 can form an excellent thin film at the same level as the resist composition of Comparative Example 1.

In Examples 1 to 6, good negative type resist patterns were obtained by irradiation with electron beams of 1:1 line and space setting with a 50 nm interval. As is also evident from comparison with Comparative Example 1, the resist composition obtained in Example 1 was excellent in both reactivity and pattern formability.

### [Examples 7 to 12]

Resist compositions of Examples 7 to 12 and Comparative Example 2 were prepared according to the compounding amounts shown in the following Table 2 (in the table, numerical values indicate parts by mass) of tetraethoxytellurium(IV) (a product from Alfa Aesar, purity: 85%) and the compounds synthesized in Synthesis Examples 2 to 4; the naphthol-modified resin (CR-1-BOC) synthesized in Synthesis Example 1-2; an acid generating agent (a product from Midori Kagaku Co., Ltd., triphenylsulfonium trifluoromethanesulfonate); an acid diffusion controlling agent (a product from Tokyo Chemical Industry Co., Ltd., trioctylamine); and a solvent (a product from Tokyo Chemical Industry Co., Ltd., propylene glycol monomethyl ether acetate). For each of the prepared resist compositions, the above evaluations (1) to (4) were carried out. Note that, for the above evaluation (1), evaluation of the solubility of compound A and CR-1-BOC constituting the compositions of Examples 7 to 12 and the solubility of CR-1-BOC constituting the composition of Comparative Example 2 was carried out. The evaluation results are shown in Table 5.

**[Table 5]**

| | | Example 7 | Example 8 | Example 9 | Example 10 | Example 11 | Example 12 | Comparative Example 2 |
|---|---|---|---|---|---|---|---|---|
| Composition | Compound A | TOX-1 0.3 | TOX-2 0.3 | TOX-3 0.3 | TOX-4 0.3 | TOX-3 0.3 | TOX-4 0.3 | None |
| | CR-1 | 0.7 | 0.7 | 0.7 | 0.7 | 0.7 | 0.7 | 1 |
| | Acid generating agent | 0.3 | 0.3 | 0.3 | 0.3 | 0.3 | 0.3 | 0.3 |
| | Acid diffusion controlling agent | 0.03 | 0.03 | 0.03 | 0.03 | 0.03 | 0.03 | 0.03 |
| | Polymerization initiator | 0 | 0 | 0 | 0 | 0.05 | 0.05 | 0 |
| | Solvent | 50 | 50 | 50 | 50 | 50 | 50 | 50 |
| Evaluation | Solubility | A | A | A | A | A | A | A |
| | Storage stability | A | A | A | A | A | A | A |
| | Film formability | A | A | A | A | A | A | A |
| | Reactivity (method B) | A | A | A | A | A | A | C |
| | Pattern formability (method A) | A | A | A | A | - | - | C |
| | Pattern formability (method B) | A | A | A | A | A | A | C |

As is evident from Table 5, it was confirmed that the compounds used in Examples 7 to 12 have excellent solubility in a safe solvent at the same level as CR-1-BOC.

For the film formability, it was confirmed that the resist compositions of Examples 5 to 8 can form an excellent thin film at the same level as the resist composition of Comparative Example 2.

Through irradiation with electron beams of 1:1 line and space setting with a 50 nm interval, good positive type resist patterns were obtained in Examples 7 to 10 (method A), and good negative type resist patterns were obtained in Examples 7 to 12 (method B). As is also evident from comparison with Comparative Example 2, the resist compositions obtained in Examples 7 to 12 were excellent in both reactivity and pattern formability.

From the above results, it was confirmed that the compounds of the present embodiment have high solubility in a safe solvent, and that the resist compositions including these compounds are superior in storage stability, film formability, high sensitivity and pattern formability, and especially for high sensitivity and pattern formability, they are superior to the compositions of Comparative Examples 1 and 2.

As long as the requirements of the present invention are met, compounds other than the compounds described in Examples also exhibit the same effects.

This application is based on Japanese Patent Application No. 2017-189340 filed on September 29, 2017, the contents of which are incorporated herein by reference.

## Claims

1. A composition for lithography, comprising a compound represented by following formula (1):
[LₓTe(OR¹)_{y}] (1)
wherein L represents a ligand other than OR¹; R¹ represents any one of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms; x represents an integer of 0 to 6; y represents an integer of 0 to 6; a total of x and y represents 1 to 6; when x represents 2 or more, a plurality of L may be the same or different from each other, and when y represents 2 or more, a plurality of R¹ may be the same or different from each other.

2. The composition for lithography according to claim 1, wherein, in the compound represented by formula (1), x represents an integer of 1 to 6.

3. The composition for lithography according to claim 1 or 2, wherein, in the compound represented by formula (1), y represents an integer of 1 to 6.

4. The composition for lithography according to any one of claims 1 to 3, wherein, in the compound represented by formula (1), R1 represents a substituted or unsubstituted, linear alkyl group having 1 to 6 carbon atoms or branched or cyclic alkyl group having 3 to 6 carbon atoms.

5. The composition for lithography according to any one of claims 1 to 4, wherein, in the compound represented by formula (1), L represents a bi- or higher-dentate ligand.

6. The composition for lithography according to any one of claims 1 to 5, wherein, in the compound represented by formula (1), L represents any one of acetylacetonato, 2,2-dimethyl-3,5-hexanedione, ethylenediamine, diethylenetriamine and methacrylic acid.

7. The composition for lithography according to any one of claims 1 to 6, wherein the composition is for a resist.

8. The composition for lithography according to any one of claims 1 to 7, further comprising a solvent.

9. The composition for lithography according to any one of claims 1 to 8, further comprising an acid generating agent.

10. The composition for lithography according to any one of claims 1 to 9, further comprising an acid diffusion controlling agent.

11. The composition for lithography according to any one of claims 1 to 10, further comprising a polymerization initiator.

12. A method for forming a pattern, comprising the steps of:
forming a resist film on a substrate using the composition for lithography according to any one of claims 1 to 11;
exposing the resist film to light; and
developing the light exposed resist film, thereby forming a pattern.

13. A compound represented by following formula (1):
[LₓTe(OR¹)_{y}] (1)
wherein L represents a ligand other than OR¹; R1 represents any one of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms; x represents an integer of 0 to 6; y represents an integer of 0 to 6; a total of x and y represents 1 to 6; when x represents 2 or more, a plurality of L may be the same or different from each other, and when y represents 2 or more, a plurality of R¹ may be the same or different from each other.
